(19) **Europäisches Patentamt**
**European Patent Office**
**Office européen des brevets**

(11) **EP 2 437 371 B1**

(12) **EUROPÄISCHE PATENTSCHRIFT**

(45) Veröffentlichungstag und Bekanntmachung des Hinweises auf die Patenterteilung:
**28.09.2016 Patentblatt 2016/39**

(51) Int Cl.:
*H02J 3/38* *(2006.01)* *H01L 31/042* *(2006.01)*

(21) Anmeldenummer: **11004680.2**

(22) Anmeldetag: **08.06.2011**

(54) **Anschlußdose, Solarpaneel, Verwendung und Verfahren zum Erzeugen eines vorbestimmten Stroms**

Connection socket, solar panel, use and method for generating a pre-defined current

Boîte de raccordement, panneau solaire, utilisation et procédé de production d'un courant prédéterminé

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.06.2010 DE 102010023085**

(43) Veröffentlichungstag der Anmeldung:
**04.04.2012 Patentblatt 2012/14**

(73) Patentinhaber: **Yamaichi Electronics Deutschland GmbH**
**85609 Aschheim-Dornach (DE)**

(72) Erfinder: **Dirk, Michel**
**85716 Unterschleißheim (DE)**

(74) Vertreter: **Müller-Boré & Partner**
**Patentanwälte PartG mbB**
**Friedenheimer Brücke 21**
**80639 München (DE)**

(56) Entgegenhaltungen:
**WO-A2-2009/146065 DE-A1- 19 635 606**
**DE-A1-102008 008 505**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Anschlußdose, ein Solarpaneel, eine Verwendung der Anschlußdose sowie ein Verfahren zum Erzeugen eines vorbestimmten Stroms.

Herkömmliche Solarpaneele zur Erzeugung elektrischer Energie aus Sonnenlicht umfassen eine oder mehrere Solarzellengruppen, in denen je nach gewünschter von der Solarzellengruppe zur Verfügung zu stellenden Spannung und/oder Stromstärke einzelne Solarzellen parallel und/oder in Reihe geschaltet sind. Die elektrischen Anschlüsse der Solarzellengruppen des Solarmoduls werden nach außen geführt und mittels einer Anschlußdose in Form einer Gleichspannung bzw. eines Gleichstroms bereitgestellt. Abhängig von der auf das Solarpaneel wirkenden Bestrahlungsintensität durch Sonnenlicht, kann das Solarpaneel eine unterschiedliche elektrische Leistung zur Verfügung stellen.

Die Anschlußdose weist in der Regel Anschlußpole auf, an denen ein elektrischer Gleichstromverbraucher in Regel über Akkumulatoren oder ein elektrischer Wechselstromverbraucher über einen Wechselrichter angeschlossen werden kann. Mit anderen Worten sind je nach der Art des angeschlossenen elektrischen Verbrauchers unterschiedliche weitere Bauelemente notwendig, die zwischen der Anschlußdose und dem elektrischen Verbraucher geschaltet werden müssen.

Die Druckschrift DE 196 35 606 A1 offenbart eine Vorrichtung zur Erzeugung einer höheren Wechselspannung aus mehreren niedrigen Gleichspannungen, welche beispielsweise von Photovoltaikmodulen bereitgestellt werden können.

Diese Druckschrift zeigt eine Mehrzahl von Stellgliedern die mit einer Regeleinrichtung verbunden sind, wobei jedes Stellglied eine über die Zeit t vorgegebene Eingangsspannung in eine zeitlich variable Ausgangsspannung konvertiert, so daß eine vorbestimmte superpositionierte Ausgangsspannung bereitgestellt wird.

Die Druckschrift WO 2009/146065 A2 offenbart eine Anordnung von einer Mehrzahl von Solarmodulen, welche in drei Strängen in Serie an einen Wechselrichter angeschlossen sind, welcher ausgelegt ist, einen Dreiphasenwechselstrom zu erzeugen.

Die Druckschrift DE 10 2008 008 505 A1 offenbart einen Anschlußkasten für mehrere Solarpaneele zum Anschluß an einen zentralen Wechselrichter.

Es ist Aufgabe der Erfindung, eine elektrische Anschlußdose, ein Solarpaneel, eine Verwendung des Solarpaneels sowie ein Stromerzeugungsverfahren bereitzustellen, welche(s) auf vereinfachte Weise eine zuverlässige Stromversorgung von unterschiedlichen angeschlossenen Verbraucher ermöglichen bzw. ermöglicht.

Die Aufgabe wird durch die Anschlußdose gemäß Anspruch 1, das Solarpaneel gemäß Anspruch 9, die Verwendung gemäß Anspruch 10 sowie das Verfahren gemäß Anspruch 11 gelöst. Bevorzugte Ausführungsformen sind Gegenstand der abhängigen Ansprüche.

Anschlußdose gemäß einem Aspekt

Ein Aspekt der vorliegenden Erfindung betrifft eine Anschlußdose für ein Solarmodul umfassend:

- einen ersten und zweiten Anschlußpol;
- eine Anzahl von N Stellgliedern mit der Anzahl N $\geq$ 2,
  wobei jedes der N Stellglieder mit dem ersten Anschlußpol und dem zweiten Anschlußpol elektrisch verbunden ist, wobei jedes der N Stellglieder einen zugeordneten ersten elektrischen Leiterkontakt und einen zugeordneten zweiten elektrischen Leiterkontakt aufweist, und
  wobei jeder der ersten elektrischen Leiterkontakte und jeder der zweiten elektrischen Leiterkontakte mit einem zugeordneten elektrischen Leiter des Solarmoduls elektrisch kontaktierbar ist;
- eine Regeleinrichtung, welche mit jedem der N Stellglieder elektrisch verbunden ist,

wobei das n-te der N Stellglieder mit n $\in$ [1...N] einen über eine Zeit t vorgegebenen elektrischen Eingangsstrom $I_E^n(t)$, welcher über die zugeordneten ersten und zweiten elektrischen Leiterkontakte dem n-ten der Stellglieder zugeführt wird, in einen durch die Regeleinrichtung vorbestimmbaren zeitlich variablen Ausgangsstrom $I_A^n(t)$ konvertiert, so daß ein vorbestimmbarer superpositionierter Ausgangsstrom $I(t) = \sum_{n=1}^{N} I_A^n(t)$ an dem ersten und zweiten Anschlußpol bereitstellbar ist, oder

wobei das n-te der N Stellglieder mit n $\in$ [1...N] eine über die Zeit t vorgegebene elektrische Eingangsspannung $U_E^n(t)$, welche an den zugeordneten ersten und zweiten elektrischen Leiterkontakten des n-ten der N Stellglieder anliegt, in eine durch die Regeleinrichtung vorbestimmbare zeitlich variable Ausgangsspannung $U_A^n(t)$ konvertiert, so daß eine vorbestimmbare superpositionierte Ausgangsspannung $U(t) = \sum_{n=1}^{N} U_A^n(t)$ zwischen dem ersten und zweiten Anschlußpol anlegbar ist.

Der erste und zweite Anschlußpol sind ausgelegt, ein an die Anschlußdose angeschlossenes Solarmodul mit einem elektrischen Verbraucher zu verbinden. Im Betrieb fließt zwischen dem ersten und dem zweiten Anschlußpol innerhalb der Anschlußdose der nach außen wirksame, aus den einzelnen an den Stellgliedern bereitgestellten Ausgangsströmen $I_A^n(t)$ superpositionierte Ausgangsstrom $I(t)$ oder kurz der Gesamtausgangsstrom $I(t)$, wobei zwischen den zwei Anschlußpolen die superpositionierte Ausgangsspannung $U(t)$ oder kurz die Gesamtausgangsspannung $U(t)$ anliegt.

Vorteilhafterweise kann der Regeleinrichtung ein gewünschter Gesamtausgangsstrom $I_G(t)$ und/oder eine gewünschte Gesamtausgangsspannung $U_G(t)$ vorgegeben werden, welche an die Erfordernisse des an die Anschlußpole angeschlossenen Verbrauchers angepaßt sind. Die Regeleinrichtung kann beispielsweise den gewünschten Gesamtausgangsstrom $I_G(t)$ bzw. die gewünschte Gesamtausgangsspannung $U_G(t)$ speichern. Die Regeleinrichtung kann vorteilhafterweise die von den N Stellgliedern bereitgestellten Ausgangsströme $I_A^n(t)$ derart bestimmen bzw. den N Stellgliedern vorgeben, daß der durch die Superposition der Ausgangsströme $I_A^n(t)$ resultierende Gesamtausgangsstrom $I(t)$ dem gewünschten Gesamtausgangsstrom $I_G(t)$ entspricht. Dementsprechend kann die Regeleinrichtung die von den N Stellgliedern bereitgestellten Ausgangsspannungen $U_A^n(t)$ derart bestimmen bzw. den N Stellgliedern vorgeben, daß die durch die Superposition der Ausgangsspannungen $U_A^n(t)$ resultierende Gesamtausgangsspannung $U(t)$ der gewünschten Gesamtausgangsspannung $U_G(t)$ entspricht.

Das Entsprechen im Sinne der Erfindung umfaßt eine geringe Abweichung des tatsächlich bereitgestellten Gesamtausgangsstroms $I(t)$ von dem gewünschten Gesamtausgangsstrom $I_G(t)$ von weniger als 10 Prozent oder bevorzugt weniger als 5 Prozent der maximalen gewünschten Gesamtausgangsstromstärke. Als geringe Abweichung kann angesehen werden, wenn die Differenz zwischen dem gewünschten und dem tatsächlichen Gesamtausgangsstrom $|I_G(t) - I(t)|$ kleiner als etwa 100 mA, bevorzugt kleiner als etwa 50 mA, insbesondere kleiner als etwa 10 mA zu jedem Zeitpunkt t ist. Mit anderen Worten gilt: $I_G(t) \approx I(t)$ und im Idealfall der fehlerfreien Regelung gilt für den superpositionierten Ausgangsstrom :

$$I(t) = I_G(t) = \sum_{n=1}^{N} I_A^n(t).$$

Analog umfaßt das Entsprechen im Sinne der Erfindung eine geringe Abweichung der tatsächlich bereitgestellten Gesamtausgangsspannung $U(t)$ von der gewünschten Gesamtausgangsspannung $U_G(t)$ von weniger als 10 Prozent oder bevorzugt weniger als 5 Prozent der maximalen gewünschten Gesamtausgangsspannung. Als geringe Abweichung kann angesehen werden, wenn die Differenz zwischen der gewünschten und der tatsächlichen Gesamtausgangsspannung $|U_G(t) - U(t)|$ kleiner als etwa 5 V, bevorzugt kleiner als etwa 2 V, insbesondere kleiner als etwa 1 V zu jedem Zeitpunkt t ist. Mit anderen Worten gilt: $U_G(t) \approx U(t)$ und im Idealfall der fehlerfreien Regelung gilt für die superpositionierte Ausgangsspannung :

$$U(t) = U_G(t) = \sum_{n=1}^{N} U_A^n(t).$$

Vorteilhafterweise kann durch die Superposition der von den N Stellgliedern bereitgestellten N zeitlich variablen Ausgangsströme $I_A^n(t)$ mit $n \in [1...N]$ ein beliebiger Gesamtausgangsstrom $I(t)$, also insbesondere auch ein Gleichstrom oder ein Wechselstrom, bereitgestellt werden. Die Zahlen n und N sind jeweils natürliche Zahlen. Dementsprechend kann vorteilhafterweise durch die Superposition der von den N Stellgliedern bereitgestellten N zeitlich variablen Ausgangsspannung $U_A^n(t)$ mit $n \in [1...N]$ eine beliebige Gesamtausgangsspannung $U(t)$, also insbesondere auch eine Gleichspannung oder eine Wechselspannung, bereitgestellt werden. Insbesondere kann wahlweise eine Gleichspannung oder eine Wechselspannung bereitgestellt werden, wobei die Wahl bevorzugt während des betriebsgemäßen Gebrauchs der Anschlußdose mittels der Regeleinrichtung erfolgen kann. Daher können vorteilhafterweise sowohl Verbraucher an die Anschlußpole angeschlossen werden, die eine Gleichstromversorgung benötigen, als auch Verbraucher, die eine Wechselstromversorgung benötigen.

Die Anschlußdose umfaßt weiter eine Mehrzahl von zwei oder mehr (also beispielsweise 2, 3, 4, 5, 6, 7, 8, 9, 10 usw.) Stellgliedern. Jedes Stellglied ist mittelbar oder unmittelbar mit dem ersten Anschlußpol und dem zweiten Anschlußpol elektrisch verbunden. Insbesondere können zwei oder mehrere Stellglieder in Reihe geschaltet und mit den Anschlußpolen elektrisch verbunden sein. Mit anderen Worten kann zumindest ein Stellglied mittelbar über ein anderes Stellglied mit dem ersten oder dem zweiten Anschlußpol elektrisch verbunden sein.

Ein Stellglied im Sinne der Erfindung kann ein Gleichstromsteller oder ein Gleichspannungswandler, jeweils auch DC-DC-Wandler genannt, umfassen bzw. sein. Das Stellglied dient zur Strom- bzw. Spannungsübersetzung und/oder Spannungs- bzw. Stromregelung, beispielsweise mit Hilfe eines periodisch arbeitenden elektronischen Schalters und einem Energiespeicher. Der Energiespeicher kann eine Induktivität, beispielsweise eine Spule oder ein Wandler-Transformator, oder eine Kapazität, beispielsweise einen Kondensator, umfassen. Als elektronischer Schalter können beispielsweise Leistungs-MOSFET, IGBTs und Thyristoren zum Einsatz kommen. Damit die Polarität des von dem Stellglied gewandelten und bereitgestellten Ausgangsstroms bzw. die Polarität der Ausgangsspannung wechseln kann, kann ein Stellglied eine Kombination aus mehreren Gleichstromstellern umfassen. Mit anderen Worten kann dann Stellglied als Zweiquadrantensteller oder als Vierquadrantensteller ausgebildet sein.

Jedem Stellglied ist ein erster elektrischer Leiterkontakt und ein zweiter elektrischer Leiterkontakt zugeordnet, mit welchem das Stellglied elektrisch verbunden ist. Der erste und der zweite elektrische Leiterkontakt sind mit den zugeordneten elektrischen Leitern einer zugeordneten Solarzellengruppe des Solarmoduls kontaktierbar. Der Begriff "Kontakt" bzw. "kontaktieren" im Sinne der vorliegenden Erfindung beinhaltet insbesondere einen elektrischen und/oder mechanischen Kontakt. Insbesondere können die zugeordneten elektrischen Leiter der zugeordneten Solarzellengruppe des Solarmoduls an dem ersten und/oder dem zweiten elektrischen Leiterkontakt befestigt werden, beispielsweise festgelötet, geklemmt, geschraubt, usw.. Dabei kann der elektrische Kontakt unmittelbar oder mittelbar über weitere elektrisch leitfähige Bauteile erfolgen.

Die Regeleinrichtung ist mit jedem der N Stellglieder elektrisch verbunden, um die Stellglieder zu regeln oder zu steuern. Dabei kann die Regeleinrichtung jedem der N Stellglieder vorgeben, welcher Ausgangsstrom $I_A^n(t)$ bzw. welche Ausgangsspannung $U_A^n(t)$ das n-te der N Stellglieder zu einem Zeitpunkt t bereitstellen soll. Jedes der N Stellglieder konvertiert dann den von der zugeordneten Solarzellengruppe erzeugten elektrischen Eingangsstrom $I_E^n(t)$, welcher über die zugeordneten ersten und zweiten elektrischen Leiterkontakte dem n-ten der N Stellglieder bereitgestellt wird, in den durch die Regeleinrichtung vorbestimmbaren Ausgangsstrom $I_A^n(t)$. Der von dem n-ten Stellglied konvertierte Ausgangsstrom $I_A^n(t)$ ist zeitlich variabel und insbesondere periodisch. Zeitlich variabel im Sinne der Erfindung bedeutet, daß der von dem n-ten Stellglied konvertierte Ausgangsstrom $I_A^n(t)$ nicht zeitlich konstant ist, also nicht nur lediglich geringe Schwankungen beispielsweise aufgrund einer wechselnden auf die Solarzellengruppe treffende Bestrahlungsintensität aufweist. Insbesondere kann der zeitliche Verlauf innerhalb eines Zeitintervalls von einer Stunde oder einer Minute eine Mehrzahl von Schaltereignissen aufweisen, bei denen der von dem n-ten Stellglied konvertierte Ausgangsstrom $I_A^n(t)$ innerhalb einer Schaltzeit um mehr als 10 Prozent, bevorzugt um mehr als 50 Prozent, insbesondere um etwa 100 Prozent erhöht oder verringert wird. Insbesondere kann sich der konvertierte Ausgangsstrom $I_A^n(t)$ innerhalb einer Schaltzeit zwischen Null und etwa 100 Prozent eines vorbestimmten maximalen Ausgangsstrom ändern. Die Schaltzeit kann dabei bevorzugt kleiner als 1 s, weiter bevorzugt kleiner als 100 ms und insbesondere kleiner als 10 ms sein.

Alternativ oder zusätzlich kann die zeitliche Variabilität des von dem n-ten Stellglied konvertierten Ausgangsstroms $I_A^n(t)$ auch durch das Leistungsdichtespektrum des Ausgangsstroms $|I_A^n(f)|$ mit der Frequenz f beschrieben werden. Das Leistungsdichtespektrum des eines zeitlich variablen Ausgangsstroms $I_A^n(t)$ ist derart frequenzmäßig begrenzt, daß zumindest 50 Prozent, bevorzugt zumindest 90 Prozent, der elektrischen Leistung bei Frequenzen f größer als 10 mHz (also Perioden kleiner als 100 s), bevorzugt bei Frequenzen f größer als 100 mHz (also Perioden kleiner als 10 s), bereitgestellt wird. Insbesondere kann der zeitlich variable Ausgangsstroms $I_A^n(t)$ in seinem Leistungsdichtespektrum frequenzmäßig begrenzt sein, so daß zumindest 50 Prozent, bevorzugt zumindest 90 Prozent, der elektrischen Leistung bei Frequenzen f größer als 1 kHz (also Perioden kleiner als 1 ms), bevorzugt bei Frequenzen f größer als 10 kHz (also Perioden kleiner als 0,1 ms), bereitgestellt wird.

Das Solarmodul, welches ausgelegt ist, mit der Anschlußdose zu kontaktieren, weist zumindest zwei elektrische Leiterpaare auf, wobei jedes Leiterpaar mit einer zugeordneten Solarzellengruppe elektrisch verbunden ist, so daß an den zwei elektrischen Leitern des Leiterpaares die von der Solarzellengruppe erzeugte elektrische Leistung bereitgestellt wird. Ein Leiter jedes Leiterpaares ist mit einem zugeordneten ersten elektrischen Leiterkontakt eines zugeordneten der drei Stellglieder elektrisch mittelbar oder unmittelbar verbindbar, während der andere Leiter jedes Leiterpaares mit einem zugeordneten zweiten elektrischen Leiterkontakt eines zugeordneten der drei Stellglieder elektrisch mittelbar oder unmittelbar verbindbar ist. Entsprechend ist jedes der drei Stellglieder mit einer zugeordneten Solarzellengruppe des Solarmoduls elektrisch kontaktierbar.

Jedes der N Stellglieder ist mit einem zugeordneten ersten und einem zugeordneten zweiten Leiterkontakt elektrisch verbunden, so daß in Abhängigkeit von der auf die Solarzellengruppe des Solarmoduls wirkenden Bestrahlungsintensität eine elektrische Eingangsspannung $U_E^n(t)$ an dem n-ten Stellglied anliegt. Gemäß der Strom-Spannungs-Kennlinie der Solarzellengruppe fließt ein elektrischer Eingangsstrom $I_E^n(t)$, so daß dem Stellglied die Eingangsleistung $P_E^n(t)$ zur Verfügung gestellt wird. Da die Strom-Spannungs-Kennlinie des Solarmoduls nichtlinear ist, ergibt sich in Abhängigkeit von den Betriebsbedingungen, wie beispielsweise der Temperatur des Solarmoduls im Betrieb, für eine bestimmtes Spannungs-Stromstärken-Wertepaar eine maximale Eingangsleistung $P_{E,max}^n$. Dieses Spannungs-Stromstärken-Wertepaar mit maximaler Eingangsleistung ist der optimale Arbeitspunkt des Solarmoduls.

Bevorzugt ist jedes n-te der N Stellglieder ausgelegt, den Innenwiderstand des n-ten Stellglieds zwischen den mit der zugeordneten Solarzellengruppe verbundenen elektrischen Leiterkontakten zu regeln, so daß die Eingangsspannung $U_E^n(t)$ in Abhängigkeit einer bekannten Strom-Spannungs-Kennlinie des Solarmoduls einen elektrischer Eingangsstrom $I_E^n(t)$ bewirkt, so daß die Differenz zwischen der tatsächlichen Eingangsleistung $P_E^n(t)$ und der maximalen Eingangsleistung $P_{E,max}^n$ minimal bzw. Null ist. Mit anderen Worten ist jedes Stellglied ausgelegt, die zugeordnete Solarzellengruppe stets im optimalen Arbeitspunkt zu betreiben.

Das n-te Stellglied konvertiert den Eingangsstrom $I_E^n(t)$ bzw. die Eingangsspannung $U_E^n(t)$ zu dem gewünschten Ausgangsstrom $I_A^n(t)$ bzw. der gewünschten Ausgangsspannung $U_A^n(t)$. Eine gegebenenfalls überschüssige elektrische Energie, welche nicht an den Anschlußpolen bereitgestellt wird, kann durch das n-te Stellglied bzw. durch eine mit dem n-ten Stellglied verbundene elektrische Speichereinrichtung, beispielsweise ein Kondensator, gespeichert werden.

Vorteilhafterweise kann sowohl ein an die Anschlußdose bzw. an das Solarpaneel angeschlossener elektrischer Verbraucher mit einem elektrischen Strom in gewünschter Art, Stärke und/oder Spannung versorgt werden als auch jede der Solarzellengruppen des Solarmoduls gemäß der Strom-Spannungs-Kennlinien unter Bedingungen (optimaler Arbeitspunkt) betrieben werden, so daß das Solarmodul die maximale elektrische Leistung bereitstellen kann. Insbesondere können zum einen abgeschattete Solarzellengruppen des Solarmoduls, die im Gegensatz zu nicht abgeschatteten Solarzellengruppen eine sehr viel geringere Leistung erzeugen können, weiter in einem optimalen Arbeitspunkt, nämlich dem unter der Bedingung der Abschattung, betrieben werden und zum anderen kann auf die Verwendung einer Bypass-Schaltung mittels einer Bypass-Diode verzichtet werden.

Bevorzugte Ausführungsformen der Anschlußdose

Vorzugsweise sind die Stellglieder Gleichstromsteller bzw. umfassen die Stellglieder zumindest einen Metalloxid-Feldeffekttransistor. Gleichstromsteller werden auch als DC-DC-Konverter oder DC-DC-Wandler bezeichnet. Ein Gleichstromsteller wandelt einen vorgegebenen Eingangsstrom oder eine vorgegebene Eingangsspannung um, insbesondere durch periodisches Schalten und/oder mittels Zwischenpufferung von elektrischer Energie in einem Induktor oder in einer Kapazität, so daß ein anderer gewünschter Ausgangsstrom bzw. eine anderer gewünschte Ausgangsspannung am Ausgang des Gleichstromstellers entsteht. Vorteilhafterweise können der Eingangsstrom und/oder die Eingangsspannung an jedem der Gleichstromsteller derart vorbestimmt sein, daß die dem Gleichstromsteller zugeordnete Solarzellengruppe des Solarmoduls gemäß der solarzellengruppeneigenen Strom-Spannungs-Kennlinie im optimalen Arbeitspunkt arbeitet, während der Gleichstromsteller ausgangsseitig einen vorbestimmbaren bzw. gewünschten Ausgangsstrom bzw. eine gewünschte Ausgangsspannung bereitstellt. Bevorzugt umfaßt zumindest ein Stellglied oder jedes der Stellglieder zumindest einen Metalloxid-Feldeffekttransistor (MOSFET). Weiter vorzugsweise kann zumindest eines der Stellglieder auch einen IGBT (Insulated Gate Bipolar Transistor) oder einen Thyristor umfassen.

Vorzugsweise sind die N Stellglieder der Anschlußdose mittels der Regeleinrichtung miteinander zeitlich synchronisierbar, so daß ein vorbestimmbarer superpositionierter Ausgangsstrom $I(t)$ bzw. Gesamtausgangsstrom $I(t)$ und/oder eine vorbestimmbare superpositionierte Ausgangsspannung $U(t)$ bzw. Gesamtausgangsspannung $U(t)$ erzeugbar ist. Vorteilhafterweise ermöglicht eine zeitgenaue Synchronisation der einzelnen Stellglieder eine hinreichend genaue Superposition der von den N Stellgliedern bereitgestellten N zeitlich variablen Ausgangsströme $I_A^n(t)$ bzw. Ausgangsspannungen $U_A^n(t)$, so daß der resultierende Gesamtausgangsstrom $I(t)$ dem gewünschten Gesamtausgangsstrom $I_G(t)$ bzw. die resultierende Gesamtausgangsspannung $U(t)$ der gewünschten Gesamtausgangsspannung $U_G(t)$ entspricht.

Vorzugsweise umfaßt die Anschlußdose zumindest eine Rückkopplungseinrichtung, welche den superpositionierten Ausgangsstrom $I(t)$ und/oder die superpositionierte Ausgangsspannung $U(t)$ an dem ersten Anschlußpol und/oder dem zweiten Anschlußpol erfaßt, und welche mit der Regeleinrichtung verbunden ist. Vorteilhafterweise kann die Regeleinrichtung eine Korrelation zwischen dem gewünschten Gesamtausgangsstrom $I_G(t)$ und dem tatsächlichen an den Anschlußpolen bereitgestellten Gesamtausgangsstrom $I(t)$ durchführen, um beispielsweise eine Korrektur durchzuführen und die Abweichung zwischen dem gewünschten und dem tatsächlichen Gesamtausgangsstrom zu verringern. Dementsprechend kann die Regeleinrichtung auch eine Korrelation zwischen der gewünschten Gesamtausgangsspannung $U_G(t)$ und der tatsächlich bereitgestellten Gesamtausgangsspannung $U(t)$ durchführen. Die Rückkopplungseinrichtung kann beispielsweise ein Übertrager sein, welcher die Regeleinrichtung induktiv mit einem der Anschlußpole koppelt. Alternativ kann die Kopplung zwischen einem der Anschlußpole und der Regeleinrichtung auch kapazitiv oder galvanisch erfolgen, beispielsweise durch einen Kondensator, einen Widerstand oder, im einfachsten Fall, durch eine elektrische Leitung.

Vorzugsweise ist der superpositionierte Ausgangsstrom $I(t)$ ein periodischer Strom und/oder die superpositionierte Ausgangsspannung $U(t)$ eine periodische Spannung. Beispielsweise kann der Ausgangsstrom $I(t)$ ein Rechteckstrom oder ein Dreiecksstrom sein. Analog kann die Ausgangsspannung $U(t)$ eine Rechteckspannung oder eine Dreiecksspannung sein. Bevorzugt kann beispielsweise der Rechteckstrom eine Pulslänge von $T_1$ aufweisen, wobei zwischen zwei benachbarten Rechteckpulsen eine Pulslücke der Länge $T_0$ besteht. Bevorzugt kann die elektrische Leistung benachbarter Rechteckpulse von unterschiedlichen Solarzellengruppen erzeugt worden sein. Weiter bevorzugt wird die elektrische Leistung eines Rechteckpulses von genau einem Stellglied bereitgestellt. Vorteilhafterweise können die übrigen Stellglieder die von den zugeordneten Solarzellengruppen erzeugte elektrische Leistung zwischenpuffern und zu einem späteren Zeitpunkt an den Anschlußpolen bereitstellen. Weiter bevorzugt ist die Stromstärke während eines Rechteckpulses vorgegeben, wobei die Stromstärke über eine vorbestimmte Zeit, beispielsweise innerhalb einer Sekunde, innerhalb einer Minute, innerhalb von 10 Minuten oder innerhalb einer Stunde bzw. abhängig von der Tageszeit oder einer Bewölkungssituation, konstant ist. Weiter bevorzugt kann auch die Länge jedes Reckteckpulses $T_1$ über die Zeit konstant sein. Abhängig von der tatsächlichen Bestrahlungsintensität und der dadurch erzeugten elektrischen Leistung in den einzelnen Solarzellengruppen, kann die Länge der Pulslücke $T_0$ zwischen zwei benachbarten Rechteckpulsen über die Zeit variieren. Durch eine Verkleinerung der Pulslänge $T_1$ und eine Vergrößerung der Pulslücke $T_0$ kann die effektive Leistung, welche an den Anschlußpolen bereitgestellt wird, verringert werden, wobei die Stromstärke vorteilhafterweise für jeden Rechteckpuls konstant bleiben kann und zwar vorteilhafterweise unabhängig von der bereitgestellten effektiven Leistung. Analog kann statt des Rechteckstromes auch eine Rechteckspannung mit einer Pulslänge $T_1$ und einer Pulslücke $T_0$ bereitgestellt sein. Die oben zu Rechteckstrom gemachten Ausführungen gelten analog auch für eine Rechteckspannung. Dementsprechend kann auch ein Dreiecksstrom oder eine Dreiecksspannung mit einer Pulslänge $T_1$ und einer Pulslücke $T_0$ bereitgestellt sein, wobei die zu dem Rechteckstrom und der Rechteckspannung gemachten Ausführungen analog gelten.

Weiter bevorzugt ist der superpositionierte Ausgangsstrom I(t) ein Wechselstrom und/oder die superpositionierte Ausgangsspannung U(t) eine Wechselspannung. Bevorzugt können der Ausgangsstrom I(t) und/oder die Ausgangsspannung U(t) annähernd eine kontinuierliche Sinusfunktion sein. Beispielsweise kann die Sinusfunktion durch eine Abfolge von Pulsen der Länge $\Delta t = T_1$ angenähert sein, wobei innerhalb der Pulslänge $T_1$ der Gesamtausgangsstrom I(t) und/oder die Gesamtausgangsspannung U(t) im wesentlichen konstant bleibt. Mit anderen Worten gilt $I(t) \approx I(t+T_1)$ bzw. $U(t) \approx U(t+T_1)$. Bevorzugt bleibt der Gesamtausgangsstrom I(t) bzw. die Gesamtausgangsspannung U(t) innerhalb einer Toleranz von $\pm 10$ Prozent, weiter bevorzugt $\pm 5$ Prozent, des Sollwertes. Die Pulslänge $T_1$ ist bevorzugt kleiner als etwa 100 ms, weiter bevorzugt kleiner als etwa 10 ms, insbesondere kleiner als etwa 1 ms.

Insbesondere können der Gesamtausgangsstrom I(t) und/oder die Gesamtausgangsspannung U(t) eine Wiederholungsperiode T aufweisen bzw. eine Wiederholfrequenz f=1/T, wobei die Wiederholfrequenz f insbesondere etwa 16,6 Hz, etwa 50 Hz oder etwa 60 Hz betragen kann. Bei einer Pulslänge $T_1$ von etwa 10 ms entspricht die zeitliche Pulslänge $T_1$ der zeitlichen Länge einer Halbwelle eines Wechselstromes mit der Frequenz f von 50 Hz. Der Wechselstrom hätte somit eine Rechteckform. Um eine Sinusform des 50 Hz Wechselstromes zu erreichen, ist eine kürzere Pulslänge $T_1$ erforderlich, beispielsweise eine um den Faktor 10 kürzere Pulslänge $T_1$ von 1 ms.

Vorteilhafterweise kann an den Anschlußpolen der Anschlußdose ein periodischer Strom bzw. ein Wechselstrom und/oder eine periodische Spannung bzw. eine Wechselspannung bereitgestellt sein, so daß eine elektrischer Verbraucher, welcher für den Betrieb mit Wechselstrom ausgelegt ist, unmittelbar an die Anschlußdose angeschlossen werden kann. Weiter vorteilhafterweise kann ein periodischer Strom bzw. ein Wechselstrom mittels eines Transformators auf induktivem Weg in einem vorbestimmten Verhältnis transformiert werden, um eine gewünschte Stromstärke bzw. eine gewünschte Spannung zu erhalten. Gegenüber dem Fall, daß an den Anschlußpolen der Anschlußdose ein Gleichstrom bereitgestellt ist, ist es vorteilhafterweise nicht notwendig einen Wechselrichter zwischen der Anschlußdose und dem elektrischen Verbraucher, welcher mit Wechselstrom betrieben wird, zu schalten.

Vorzugsweise weist die Regeleinrichtung eine Schnittstelle auf, so daß die Regeleinrichtung mit einer externen Steuereinrichtung verbindbar ist. Vorteilhafterweise kann der Regeleinrichtung mittels der Schnittstelle ein gewünschter Gesamtausgangsstrom $I_G(t)$ und/oder eine gewünschte Gesamtausgangsspannung $U_G(t)$ übermittelt werden, so daß die Anschlußdose vorteilhafterweise in Abhängigkeit von dem an den Anschlußpolen angeschlossenen elektrischen Verbraucher zum Betrieb des angeschlossenen Verbrauchers konfiguriert werden kann. Insbesondere können dann in zeitlicher Reihenfolge unterschiedliche Verbraucher angeschlossen sein. Beispielsweise können in zeitlicher Reihenfolge Gleichstrom- und Wechselstromverbraucher unmittelbar an den Anschlußpolen der Anschlußdose angeschlossen sein.

Insbesondere kann die Regeleinrichtung auch einen Mikroprozessor aufweisen. Bevorzugt umfaßt die Anschlußdose eine Stromquelle, insbesondere einen Akkumulator, um beispielsweise die Regeleinrichtung und/oder die Schnittstelle zu betreiben. Die Stromquelle kann regenerativ, d.h. wiederaufladbar sein, wobei das Aufladen mittels des an die Anschlußdose angeschlossenen Solarmoduls erfolgen kann, wenn dieses beleuchtet wird. Die Stromquelle kann vorzugsweise auch über den über die Anschlußpole fließenden Strom geladen werden. Weiter bevorzugt kann die Stromquelle über eine externe Ladevorrichtung geladen werden. Vorteilhafterweise kann die Regeleinrichtung und/oder die Schnittstelle auch betrieben werden, wenn das Solarpaneel nicht durch die Sonne beleuchtet wird.

Vorzugsweise ist die Schnittstelle eine galvanische, eine opto-elektronische, eine kapazitive und/oder eine induktive Schnittstelle. Bevorzugt kann die Schnittstelle ein Steckverbinder, eine Radiofrequenz-Verbindung bzw. eine Verbindung mittels elektromagnetischer Wellen und/oder eine Glasfaserverbindung sein.

Vorteilhafterweise ist eine Fernabfrage der in der Regeleinrichtung erfaßten bzw. gespeicherten Betriebsparameter über die Schnittstelle möglich. Weiter vorteilhafterweise kann ein unbefugter Eingriff in das Solarpaneel (z.B. Vandalismus oder Diebstahl) über die Schnittstelle an die externe Steuereinrichtung gemeldet werden. Ferner ist es möglich Betriebsparameter vorzugeben, wie beispielsweise die Vorgabe des gewünschten Gesamtausgangsstromes $I_G(t)$.

Vorzugsweise umfaßt die Anschlußdose zumindest eine Meßeinrichtung, welche mit der Regeleinrichtung verbunden ist. Vorteilhafterweise können durch die zumindest eine Meßeinrichtung Betriebszustände der Anschlußdose detektiert werden, um beispielsweise die Anschlußdose vor Schaden zu schützen. Beispielsweise kann die Anschlußdose eine Temperaturmeßeinrichtung umfassen, welche die Betriebstemperatur im Inneren der Anschlußdose oder beispielsweise die Temperatur der Stellglieder erfaßt. Bei einer Überschreitung der zulässigen Betriebstemperatur kann bzw. können beispielsweise ein Stellglied oder mehrere Stellglieder überbrückt werden, so daß kein Schaden durch eine zu hohe Betriebstemperatur entsteht. Gleichzeitig kann eine Warnmeldung über die Schnittstelle der Anschlußdose an eine externe Einrichtung gesendet werden.

Solarpaneel gemäß einem Aspekt

Ein weiterer Aspekt der vorliegende Erfindung betrifft ein Solarpaneel umfassend:

- zumindest ein Solarmodul mit zumindest vier elektrischen Leitern und
- eine Anschlußdose gemäß einem der vorigen Ansprüche, wobei jeder der ersten elektrischen Leiterkontakte der Anschlußdose und jeder der zweiten elektrischen Leiterkontakte mit einem zugeordneten elektrischen Leiter des Solarmoduls elektrisch kontaktiert ist.

In anderen Worten kann das Solarpanel umfassen: ein Solarmodul, beispielsweise mit einem im wesentlichen plattenförmigen Körper, mit zumindest zwei spannungserzeugenden Solarzellengruppen, zumindest vier mit den zumindest zwei Solarzellengruppen verbundenen Leiterbänder, die an einer Oberfläche des Solarmoduls aus diesem herausgeführt sind und zumindest eine erfindungsgemäße Anschlußdose.

Verwendung gemäß einem Aspekt

Ein weiterer Aspekt der vorliegenden Erfindung betrifft die Verwendung einer erfindungsgemäßen Anschlußdose, um einen elektrischen Verbraucher mit einem Solarmodul zu kontaktieren, wobei jeder der ersten elektrischen Leiterkontakte der Anschlußdose und jeder der zweiten elektrischen Leiterkontakte mit einem zugeordneten elektrischen Leiter des Solarmoduls elektrisch kontaktiert ist und wobei der elektrische Verbraucher mit einem ersten Anschlußpol und einem zweiten Anschlußpol der Anschlußdose elektrisch verbunden ist.

Verfahren gemäß einem Aspekt

Ein weiterer Aspekt der vorliegenden Erfindung betrifft ein Verfahren zum Erzeugen eines vorbestimmten Stroms, d.h. eines vorbestimmten Ausgangsstroms I(t) oder einer vorbestimmten Ausgangsspannung U(t), umfassend die folgenden Schritte:

- Bereitstellen eines erfindungsgemäßen Solarpaneels,
- Vorbestimmen eines Ausgangsstroms I(t) und/oder einer Ausgangsspannung U(t);
- Bereitstellen des vorbestimmten Ausgangsstroms I(t) und/oder der Ausgangsspannung U(t) an der Regeleinrichtung des Solarpaneels;
- Regeln einer Anzahl von N Stellgliedern des Solarpaneels mittels der Regeleinrichtung, wobei die Anzahl $N \geq 2$ ist, so daß das n-te der N Stellglieder mit $n \in [1...N]$ einen über eine Zeit t vorgegebenen elektrischen Eingangsstrom $I_E^n(t)$ in einen durch die Regeleinrichtung vorbestimmbaren zeitlich variablen Ausgangsstrom $I_A^n(t)$ konvertiert, und Überlagern der N zeitlich variablen Ausgangsströme $I_A^n(t)$, um einen superpositionierten Ausgangsstrom

$$I(t) = \sum_{n=1}^{N} I_A^n(t)$$ an dem ersten und zweiten Anschlußpol des Sölarpaneels bereitzustellen, oder

- Regeln einer Anzahl von N Stellgliedern des Solarpaneels mittels der Regeleinrichtung, wobei die Anzahl $N \geq 2$ ist, so daß das n-te der N Stellglieder mit $n \in [1...N]$ einer über eine Zeit t vorgegebenen elektrischen Eingangsspannung

$U_E^n(t)$ in eine durch die Regeleinrichtung vorbestimmbare zeitlich variable Ausgangsspannung $U_A^n(t)$ konvertiert, und Überlagern der N zeitlich variablen Ausgangsspannungen $U_A^n(t)$, um eine superpositionierte Ausgangsspannung $U(t) = \sum_{n=1}^{N} U_A^n(t)$ an dem ersten und zweiten Anschlußpol des Solarpaneels bereitzustellen.

Dabei kann das Bereitstellen des vorbestimmten superpositionierten Ausgangsstroms I(t) bzw. des Gesamtausgangsstroms I(t) und/oder der superpositionierten Ausgangsspannung U(t) bzw. der Gesamtausgangsspannung U(t) an der Regeleinrichtung umfassen, daß der gewünschte Ausgangsstrom $I_G(t)$ und/oder die gewünschte Ausgangsspannung $U_G(t)$ insbesondere von einer externen Steuereinrichtung beispielsweise über eine Schnittstelle zu der Regeleinrichtung übertragen wird bzw. werden. Alternativ oder zusätzlich können gewünschter Gesamtausgangsstrom $I_G(t)$ und/oder gewünschte Gesamtausgangsspannung $U_G(t)$ in der Regeleinrichtung abrufbar gespeichert sein, beispielsweise in einer Speichereinrichtung wie einem ROM, einem EEPROM, eine festen Verdrahtung bzw. Verschaltung oder ähnliches. Es versteht sich, daß das Vorbestimmen des Ausgangsstroms I(t) und/oder der Ausgangsspannung U(t) gleichbedeutend mit der Auswahl des gewünschten Gesamtausgangsstroms $I_G(t)$ und/oder der gewünschten Gesamtausgangsspannung $U_G(t)$ ist.

Figurenbeschreibung

Nachfolgend werden bevorzugte Ausführungsformen der vorliegenden Erfindung anhand der beigefügten Zeichnungen beispielhaft erläutert. Es zeigen:

Figur 1:       einen schematischen Aufbau einer Ausführungsform eines Solarpaneels;

Figuren 2a-d:  die Erzeugung eines zeitlich zumindest zeitweise konstanten Gesamtausgangsstroms durch die Superposition dreier zeitlich variierender Ausgangsströme; und

Figuren 3a-c:  die Erzeugung eines sinusförmigen Gesamtausgangsstroms durch die Superposition zweier zeitlich variierender Ausgangsströme.

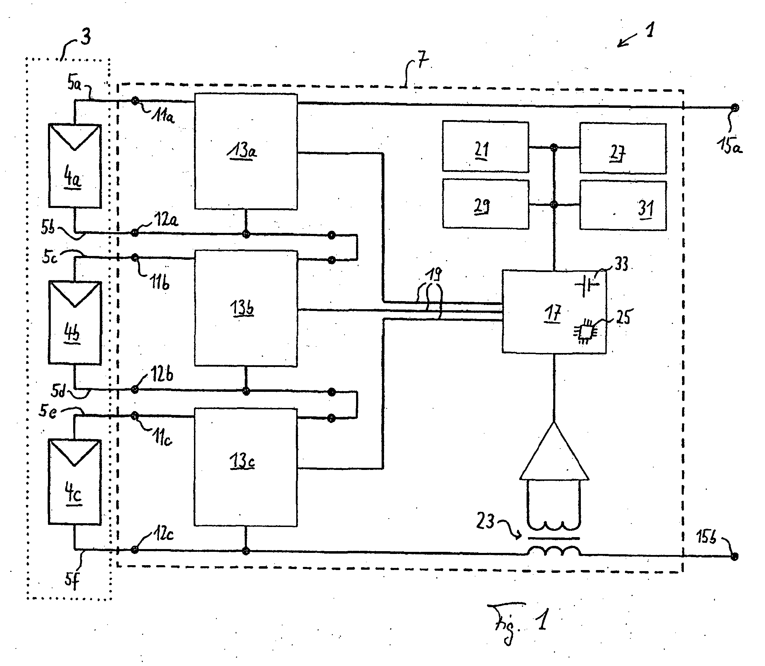

Figur 1 zeigt einen schematischen Aufbau einer Ausführungsform eines Solarpaneels 1 mit einem Solarmodul 3, welches auf einer Bestrahlungsseite drei spannungserzeugende Solarzellengruppen 4a, 4b, 4c aufweist, deren elektrische Leiter 5a, 5b, 5c, 5d, 5e, 5f auf einer der Bestrahlungsseite abgewandten Anschlußseite aus dem Solarmodul 3 herausgeführt und mit einer Anschlußdose 7 kontaktiert sind. Die Anschlußdose 7 ist an bzw. auf der Anschlußseite des Solarmoduls 3 an bzw. auf diesem angeordnet bzw. befestigt.

Die Anschlußdose 7 umfaßt in dieser Ausführungsform eine Anzahl N von drei ersten elektrischen Leiterkontakten 11 a bis 11 c, ein Anzahl N von drei zweiten elektrischen Leiterkontakten 12a bis 12c und eine Anzahl N von drei Stellgliedern 13a, 13b, 13c. Jedes der N Stellglieder 13a, 13b, 13c ist mit einem zugeordneten ersten elektrischen Leiterkontakt 11 a, 11 b, 11 c und einem zugeordneten zweiten elektrischen Leiterkontakt 12a, 12b, 12c elektrisch verbunden.

Die drei ersten elektrischen Leiterkontakte 11 a bis 11 c sind beim betriebsgemäßen Gebrauch des Solarpaneels 1 jeweils mit einem zugeordneten elektrischen Leiter 5a, 5c, 5e des Solarmoduls 3 elektrisch kontaktiert. Mit anderen Worten ist ein erster 11a der drei ersten elektrischen Leiterkontakte mit dem ersten elektrischen Leiter 5a kontaktiert, ein zweiter 11 b der drei ersten elektrischen Leiterkontakte mit dem dritten elektrischen Leiter 5c kontaktiert und ein dritter 11f f der drei ersten elektrischen Leiterkontakte mit dem fünften elektrischen Leiter 5e des Solarmoduls 3 kontaktiert.

Entsprechend sind die drei zweiten elektrischen Leiterkontakte 12a bis 12c beim betriebsgemäßen Gebrauch des Solarpaneels 1 jeweils mit einem zugeordneten elektrischen Leiter 5b, 5d, 5f des Solarmoduls 3 elektrisch kontaktiert. Mit anderen Worten ist ein erster 12a der drei zweiten elektrischen Leiterkontakte mit dem zweiten elektrischen Leiter 5b kontaktiert, ein zweiter 12b der drei zweiten elektrischen Leiterkontakte mit dem vierten elektrischen Leiter 5d kontaktiert und ein dritter 12f der drei zweiten elektrischen Leiterkontakte mit dem sechsten elektrischen Leiter 5f des Solarmoduls 3 kontaktiert.

Es versteht sich, daß die Anzahl N im Sinne der Erfindung jede natürliche Zahl größer als 1 sein kann, also insbesondere 2, 3, 4, 5, 6, 7, 8, 9, 10 usw.. Bevorzugt entspricht die Anzahl N der Stellglieder 13a, 13b, 13c der Anzahl der Solarzellengruppen 4a, 4b, 4c des Solarmoduls 3, so daß jedes der Stellglieder 13a, 13b, 13c mit einer zugeordneten Solarzellengruppe 4a, 4b, 4c des Solarmoduls 3 über die ersten Leiterkontakte 11a bis 11 c und die zweiten Leiterkontakte 12a bis 12c elektrisch verbunden ist. Mit anderen Worten ist das erste Stellglied 13a über den ersten der ersten und zweiten elektrischen Leiterkontakte 11a, 12a mit der ersten Solarzellengruppe 4a elektrisch verbunden. Analog ist das zweite Stellglied 13b über den zweiten der ersten und zweiten elektrischen Leiterkontakte 11 b, 12b mit der zweiten Solarzellengruppe 4b und das dritte Stellglied 13c über den dritten der ersten und zweiten elektrischen Leiterkontakte 11 c, 12c mit der dritten Solarzellengruppe 4c elektrisch verbunden.

Die Stellglieder 13a, 13b, 13c sind jeweils unmittelbar oder mittelbar über zumindest eines der Stellglieder 13a, 13b, 13c mit einem ersten 15a und zweiten 15b Anschlußpol der Anschlußdose 7 kontaktiert. Die Stellglieder 13a, 13b, 13c stellen jeweils einen elektrischen Kontakt zwischen dem ersten und zweiten Anschlußpol 15a, 15b und den Leiterkontakten 11 a bis 11 c, 12a bis 12c her, welche dem jeweiligen Stellglied 13a, 13b, 13c zugeordnet sind.

Ein von der ersten Solarzellengruppe 4a erzeugter, über die Zeit t variabler elektrischer Eingangsstrom $I_E^{[1]}(t)$, welcher über die elektrischen Leiter 5a, 5b sowie die Leiterkontakte 11 a, 12a zu dem ersten Stellglied 13a und wieder zurück zur ersten Solarzellengruppe 4a fließt, wird durch das erste Stellglied 13a in einen vorbestimmbaren Ausgangsstrom $I_A^{[1]}(t)$ konvertiert, welcher ebenfalls zeitlich variabel sein kann. Analog wird ein von der zweiten Solarzellengruppe 4b erzeugter elektrischer Eingangsstrom $I_E^{[2]}(t)$, welcher über die elektrischen Leiter 5c, 5d sowie die Leiterkontakte 11 b, 12b zu dem zweiten Stellglied 13b fließt, durch das zweite Stellglied 13b in einen vorbestimmbaren Ausgangsstrom $I_A^{[2]}(t)$ konvertiert und ein von der dritten Solarzellengruppe 4c erzeugter elektrischer Eingangsstrom $I_E^{[3]}(t)$, welcher über die elektrischen Leiter 5e, 5f sowie die Leiterkontakte 11 c, 12c zu dem dritten Stellglied 13c fließt, wird durch das dritte Stellglied 13c in einen vorbestimmbaren Ausgangsstrom $I_A^{[3]}(t)$ konvertiert. Die Ausgangsströme der einzelnen Stellglieder 13a, 13b, 13c addieren sich zu einem Gesamtausgangsstrom I(t), welcher über den ersten und zweiten Anschlußpol 15a, 15b bereitgestellt werden kann. Der Gesamtausgangsstrom I(t) ist als Summe der Ausgangsströme in Abhängigkeit von der Anzahl N der Stellglieder 13a, 13b, 13c durch die Gleichung

$$I(t) = \sum_{n=1}^{N} I_A^{[n]}(t) \qquad\qquad (1)$$

gegeben.

Alternativ kann eine von der ersten Solarzellengruppe 4a erzeugte elektrische Eingangsspannung $U_E^{[1]}(t)$, welche zwischen den elektrischen Leitungen 5a, 5b sowie den Leiterkontakten 11a, 12a anliegt und dem Stellglied 13a zugeführt wird, durch das Stellglied 13a in eine vorbestimmbare Ausgangsspannung $U_A^{[1]}(t)$ konvertiert werden. Dementsprechend kann eine von der zweiten Solarzellengruppe 4b erzeugte elektrische Eingangsspannung $U_E^{[2]}(t)$, welche zwischen den elektrischen Leitungen 5c, 5d sowie den Leiterkontakten 11b, 12b anliegt und dem Stellglied 13b zugeführt wird, durch das Stellglied 13b in eine vorbestimmbare Ausgangsspannung $U_A^{[2]}(t)$ konvertiert werden und eine von der dritten Solarzellengruppe 4c erzeugte elektrische Eingangsspannung $U_E^{[3]}(t)$, welche zwischen den elektrischen Leitungen 5e, 5f sowie den Leiterkontakten 11c, 12c anliegt und dem Stellglied 13c zugeführt wird, kann durch das Stellglied 13c in eine vorbestimmbare Ausgangsspannung $U_A^{[3]}(t)$ konvertiert werden. Die Ausgangsspannungen der einzelnen Stellglieder 13a, 13b, 13c addieren sich zu einer Gesamtausgangsspannung U(t), welche ebenfalls über den ersten und zweiten Anschlußpol 15a, 15b bereitgestellt werden bzw. anliegen kann. Die Gesamtausgangsspannung U(t) ist als Summe der Ausgangsspannungen in Abhängigkeit von der Anzahl N der Stellglieder 13a, 13b, 13c durch die Gleichung

$$U(t) = \sum_{n=1}^{N} U_A^{[n]}(t) \qquad\qquad (2)$$

gegeben.

Unabhängig davon, ob eine durch die Anschlußdose 7 ein vorbestimmter Gesamtausgangsstrom I(t) oder eine vorbestimmte Gesamtausgangsspannung U(t) bereitgestellt wird, können die Anschlußpole 15a, 15b vorzugsweise als Anschlußkabel oder als Verbinder ausgebildet sein.

Die in der Figur 1 gezeigte Anschlußdose 7 umfaßt eine Regeleinrichtung 17, welche mit den Stellgliedern 13a, 13b, 13c über die Steuerleitungen 19 verbunden ist. Es versteht sich, daß die Stellglieder 13a, 13b, 13c auch mittels einer einzigen Steuerleitung miteinander und mit der Regeleinrichtung 17 verbunden sein können. Die Regeleinrichtung speichert vorzugsweise den gewünschten Ausgangsstrom $I_G(t)$ bzw. die gewünschte Ausgangsspannung $U_G(t)$. Gemäß den in der Regeleinrichtung 17 gespeicherten vorbestimmten Werten konvertieren die Stellglieder 13a, 13b, 13c die durch die Solarzellengruppen 4a, 4b, 4c des Solarmoduls 3 erzeugten Eingangsströme $I_E^{[1]}(t)$, $I_E^{[2]}(t)$, $I_E^{[3]}(t)$ derart zu zugehörigen Ausgangsströmen $I_A^{[1]}(t)$, $I_A^{[2]}(t)$, $I_A^{[3]}(t)$, daß der nach Gleichung (1) resultierende Gesamtausgangsstrom I(t) einem gewünschten Gesamtausgangsstrom $I_G(t)$ entspricht. Entsprechend können die von dem Solarmodul 3 erzeugten Eingangsspannungen derart zu zugehörigen Ausgangsspannungen konvertiert werden, daß die nach Gleichung (2) resultierende Gesamtausgangsspannung U(t) einer gewünschten Gesamtausgangsspannung $U_G(t)$ entspricht.

Bevorzugt ist in der Regeleinrichtung 17 die Strom-Spannungs-Kennlinie zumindest einer der Solarzellengruppen 4a, 4b, 4c, bevorzugt jeder der Solarzellengruppen 4a, 4b, 4c, gespeichert, so daß die Regeleinrichtung 17 den Innenwiderstand zumindest eines der zugeordneten Stellglieder 13a, 13b, 13c, bevorzugt jedes der zugeordneten Stellglieder 13a, 13b, 13c, derart vorgeben kann, daß durch Einstellen des Innenwiderstandes die zugeordnete Solarzellengruppe gemäß der gespeicherten Strom-Spannungs-Kennlinie im optimalen Arbeitspunkt gehalten werden kann, um vorteilhafterweise die durch die Solarzellengruppe abgegebene elektrische Leistung zu maximieren.

In der in Fig. 1 gezeigten bevorzugten Ausführungsform umfaßt die Regeleinrichtung 17 eine Schnittstelle 21, so daß die Regeleinrichtung 17 mit einer externen Steuereinrichtung (nicht gezeigt) verbindbar ist. Die Schnittstelle 21 kann mittels einer galvanischen bzw. elektrischen oder einer opto-elektronischen Verbindung ausgebildet sein, so daß die Regeleinrichtung 17 mittels Steuerleitungen, beispielsweise elektrische Kabel oder Glasfaserkabel, mit der externen Steuereinrichtung verbunden sein kann. Die Schnittstelle 21 kann auch als kapazitive und/oder induktive Schnittstelle ausgebildet sein, die eine berührungsfreie Verbindung, insbesondere mittels elektromagnetischer Wellen, zwischen Regeleinrichtung 17 und externer Steuereinrichtung herstellen kann. Mittels der Steuerleitungen bzw. der berührungsfreien Verbindung, ist bevorzugt eine Fernabfrage zu den in der Regeleinrichtung 17 erfaßten bzw. gespeicherten Betriebsparameter möglich. Ferner ist es möglich der Regeleinrichtung 17 Betriebsparameter vorzugeben, wie beispielsweise die Vorgabe des gewünschten Gesamtausgangsstromes $I_G(t)$ bzw. der gewünschten Gesamtausgangsspannung $U_G(t)$.

Die Anschlußdose in der in Fig. 1 gezeigten bevorzugten Ausführungsform umfaßt einen Übertrager 23 als bevorzugte Rückkopplungseinrichtung 23, welcher den an dem zweiten Anschlußpol 15b bereitgestellten Gesamtausgangsstrom $I(t)$ bzw. die Gesamtausgangsspannung $U(t)$ induktiv mit der Regeleinrichtung 17 koppelt.

Vorteilhafterweise kann die Regeleinrichtung 17 eine Korrelation zwischen dem gewünschten Gesamtausgangsstrom $I_G(t)$ und dem tatsächlichen an den Anschlußpolen 15a, 15b bereitgestellten Gesamtausgangsstrom $I(t)$ durchführen, um beispielsweise eine Korrektur derart durchzuführen, daß die Abweichung zwischen dem gewünschten und dem tatsächlichen Gesamtausgangsstrom verringert bzw. minimal wird. Dementsprechend kann die Regeleinrichtung 17 auch eine Korrelation zwischen der gewünschten Gesamtausgangsspannung UG(t) und der tatsächlich bereitgestellten Gesamtausgangsspannung $U(t)$ durchführen. Die Rückkopplungseinrichtung 23 kann beispielsweise ein Übertrager 23 sein, welcher die Regeleinrichtung 17 induktiv mit einem der Anschlußpole 15a, 15b koppelt. Alternativ kann die Kopplung zwischen einem der Anschlußpole 15a, 15b und der Regeleinrichtung 17 auch kapazitiv oder galvanisch erfolgen, beispielsweise durch einen Kondensator, einen Widerstand oder lediglich durch eine elektrische Leitung.

Um die Kommunikation über die Schnittstelle 21 und/oder die Regelung des Gesamtausgangsstroms $I(t)$ bzw. der Gesamtausgangsspannung $U(t)$ zu ermöglichen, kann die Regeleinrichtung 17 vorzugsweise einen Mikroprozessor 25 umfassen. Bevorzugt umfaßt die Regeleinrichtung 17 zur Erfassung der aktuellen Betriebsparameter eine Strommeßeinrichtung 27 und/oder eine Spannungsmeßeinrichtung 29 und/oder eine Temperaturmeßeinrichtung 31.

Beispielsweise können die aktuellen Werte der Ausgangsströme $I_A^{[n]}(t)$, des Gesamtausgangsstroms $I(t)$, der Ausgangsspannungen $U_A^{[n]}(t)$ und/oder der Gesamtausgangsspannung $U(t)$ mittels der Strommeßeinrichtung 27 bzw. der Spannungsmeßeinrichtung 29 erfaßt werden, um beispielsweise zur Regelung der Stellglieder 13a, 13b, 13c verwendet zu werden. Alternativ oder zusätzlich können die aktuellen Werte der externen Steuereinrichtung (nicht gezeigt) zur Verfügung gestellt werden.

Die Temperaturmeßeinrichtung 31 kann beispielsweise die Betriebstemperatur der Anschlußdose 7 erfassen. Die durch die Temperaturmeßeinrichtung 31 erfaßten bzw. gemessenen Temperaturen können der Regeleinrichtung 17 bzw. der externen Steuereinrichtung bereitgestellt werden, um den Betriebszustand der Anschlußdose 7 bzw. des Solarpaneels 1 zu überwachen. Bei einer Betriebstemperatur außerhalb eines vorbestimmten Betriebstemperaturbereichs kann die Anschlußdose 7 bzw. das Solarpaneel 1 vorzugsweise mittels der externen Steuereinrichtung oder der Regeleinrichtung 17 abgeschaltet werden.

Um die Regeleinrichtung 17 bzw. den Mikroprozessor 25 mit elektrischer Energie zu versorgen, umfaßt die Anschlußdose 7 vorzugsweise eine Stromquelle 33. Die Stromquelle 33 kann beispielsweise ein Akkumulator sein, welcher durch das Solarmodul 3 geladen wird, wenn dieses beleuchtet wird. Alternativ oder zusätzlich kann der Akkumulator mittels des über die Anschlußpole 15a, 15b fließenden Stroms geladen werden oder über eine an die Schnittstelle 21 angeschlossene Ladevorrichtung. Vorteilhafterweise kann die Regeleinrichtung 17 auch betrieben werden, wenn das Solarmodul 3 nicht beleuchtet wird bzw. wenn kein Strom über die Anschlußpole 15a, 15b fließt.

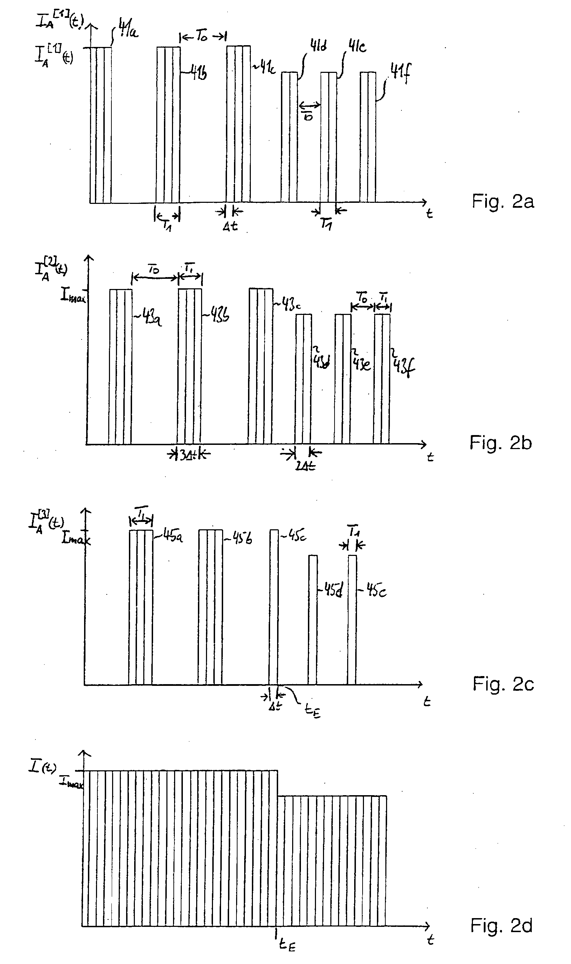

Die **Figuren 2a-d** zeigen die Erzeugung eines zeitlich zumindest zeitweise konstanten Gesamtausgangsstroms $I(t)$ durch die Superposition dreier zeitlich variierender Ausgangsströme $I_A^{[1]}(t)$, $I_A^{[2]}(t)$ und $I_A^{[1]}(t)$. Dabei zeigt die Figur 2a die über die Zeit t aufgetragene Ausgangsstromstärke $I_A^{[1]}(t)$ eines ersten Ausgangsstroms, die Figur 2b die über die Zeit t aufgetragene Ausgangsstromstärke $I_A^{[2]}(t)$ eines zweiten Ausgangsstroms und die Figur 2c die über die Zeit t aufgetragene Ausgangsstromstärke $I_A^{[3]}(t)$ eines dritten Ausgangsstroms. Die Figur 2d zeigt die Stromstärke des Gesamtausgangsstroms $I(t)$, welcher durch die Superposition der einzelnen Ausgangsströme $I_A^{[1]}(t)$, $I_A^{[2]}(t)$ und $I_A^{[3]}(t)$ erzeugt wird.

Der in der Figur 2a gezeigte erste Ausgangsstrom $I_A^{[1]}(t)$ kann beispielsweise durch das erste Stellglied 13a der in der Figur 1 gezeigten Ausführungsform einer Anschlußdose 7 bereitgestellt werden. Dabei umfaßt der gezeigte zeitliche Verlauf des ersten Ausgangsstroms $I_A^{[1]}(t)$ eine Mehrzahl von rechteckförmigen Stromstärkeimpulsen bzw. Rechteckimpulsen 41 a bis 41 f unterschiedlicher Zeitdauer. Bevorzugt ist die Zeitdauer $T_1$ eines Rechteckimpulses ein ganzzahliges Vielfaches eines kleinsten gemeinsamen Zeitintervalls $\Delta t$. Beispielsweise weisen die Rechteckimpulse 41 a bis 41 c eine Zeitdauer $T_1$ von $3\Delta t$ auf mit einer dazwischenliegenden Pulslücke der Länge $T_0$, während die nachfolgenden Rechteckimpulse 41 d bis 41 f eine geringere Zeitdauer $T_1$ von $2\Delta t$ aufweisen, die zudem eine geringere Stromstärke gegenüber den vorangehenden Rechteckimpulsen 41 a bis 41 c aufweisen. Weiter ist die Pulslücke $T_0$ zwischen den benachbarten Rechteckimpulsen auf $3\Delta t$ verkürzt.

Die Zeitdauer des Rechteckimpulses $T_1 = n\Delta t$, wobei n eine natürliche Zahl ist, und die Stromstärke $I_A^{[1]}(t)$ eines der Rechteckimpulse, welche von dem ersten Stellglied 13a bereitgestellt wird, kann beispielsweise von der Beleuchtungsintensität abhängen, welche auf die mit dem ersten Stellglied 13a elektrisch verbundenen Solarzellengruppe 4a trifft. Bei einer maximalintensiven Bestrahlung der Solarzellengruppe 4a, welche dann eine maximale Eingangsstromstärke $I_E^{[1]}(t)$ liefert, kann das Stellglied 13a beispielsweise eine konstante vorbestimmte Ausgangsstromstärke $I_A^{[1]}(t)=I_{max}$ liefern. Sinkt jedoch die Bestrahlungsintensität auf die Solarzellengruppe 4a, so sinkt auch die zur Verfügung stehende Eingangsstromstärke. Da das Stellglied weiterhin eine vorbestimmte Ausgangsstromstärke liefern soll, kann das Stellglied 13a statt eines konstanten Ausgangsstromes eine Folge von Rechteckimpulsen der gewünschten Stromstärke bereitstellen und zwar derart, daß die von der Solarzellengruppe 4a bereitgestellte mittlere elektrische Leistung im wesentlichen der von dem Stellglied 13a bereitgestellten elektrischen Leistung entspricht. Mit anderen Worten wird die an dem Stellglied 13a bereitgestellte elektrische Leistung gegenüber der von der Solarzellengruppe 4a erzeugten elektrischen Leistung im wesentlichen lediglich um die Verlustleistung des Stellglieds 13a gemindert. Je geringer also die von der Solarzellengruppe 4a erzeugte elektrische Leistung ist, desto kürzer kann die Zeitdauer t der vom Stellglied 13a bereitgestellten Rechteckimpulse 41 a bis 41f bei konstanter Stromstärke sein.

Der in der Figur 2b gezeigte zweite Ausgangsstrom $I_A^{[2]}(t)$ kann beispielsweise durch das zweite Stellglied 13b der in der Figur 1 gezeigten Anschlußdose 7 bereitgestellt sein. Dabei entspricht der gezeigte zeitliche Verlauf des eine Mehrzahl von Rechteckimpulsen 43a bis 43f umfassenden Ausgangsstroms $I_A^{[2]}(t)$ einem um die Zeit von $3\Delta t$ verzögerten Verlauf des in der Figur 2a gezeigten Ausgangsstroms $I_A^{[1]}(t)$. Auch die ersten drei in Figur 2b gezeigten Rechteckimpulse 43a bis 43c weisen eine Zeitdauer bzw. Pulslänge $T_1$ von $3\Delta t$ auf, während die nachfolgenden Rechteckimpulse 43d bis 43f eine geringere Zeitdauer $T_1$ von $2\Delta t$ aufweisen.

Schließlich kann der in der Figur 2c gezeigte Ausgangsstrom $I_A^{[3]}(t)$ beispielsweise durch das dritte Stellglied 13c der in der Figur 1 gezeigten Anschlußdose 7 bereitgestellt werden. Dabei entspricht der gezeigte zeitliche Verlauf des eine Mehrzahl von Rechteckimpulsen 45a bis 45e umfassenden Ausgangsstroms $I_A^{[3]}(t)$ zunächst einem um die Zeit von $6\Delta t$ verzögerten Verlauf des in der Figur 2a gezeigten Ausgangsstroms $I_A^{[1]}(t)$, wobei ersten zwei in Figur 2c gezeigten Rechteckimpulse 45a, 45b auch eine Zeitdauer bzw. Pulslänge $T_1$ von $3\Delta t$ aufweisen. Der nachfolgende Rechteckimpuls 45c erreicht zwar noch die maximale Stromstärke $I_{max}$ jedoch nur noch eine minimale Zeitdauer $T_1$ von $\Delta t$. Der in Figur 2c gezeigte zeitliche Verlauf des Ausgangsstroms $I_A^{[3]}(t)$ kann beispielsweise aufgrund einer derartigen partiellen Abschattung zum Ereigniszeitpunkt $t_E$ des Solarpaneels resultieren, daß lediglich das mit dem dritten Stellglied 13c elektrisch verbundenen Solarzellengruppe 4c durch Schattenwurf beeinträchtigt ist. Die nachfolgenden Rechteckimpulse 45d, 45e weisen zudem eine verringerte Stromstärke auf.

Der in der Figur 2d gezeigte Gesamtausgangsstrom I(t) ist die Summe der in den Figuren 2a bis 2c gezeigten Ausgangsströme. In dem in den Figuren 2a bis 2d gezeigten Beispiel ist die Regeleinrichtung 17 der in der Figur 1 gezeigten Ausführungsform der Anschlußdose 7 ausgelegt, einen möglichst kontinuierlichen Gesamtausgangsstrom I(t) an den Anschlußpolen 15a, 15b bereitzustellen. Bis zum Ereigniszeitpunkt $t_E$, bei welchem die partielle Abschattung der dritten Solarzellengruppe 4c auftritt, ist der Gesamtausgangsstrom I(t) gleich dem maximalen Ausgangsstrom $I_{max}$. In diesem Zeitraum bis zum Ereigniszeitpunkt $t_E$ werden die Stellglieder 13a bis 13c derart von der Regeleinrichtung 17 geregelt, daß jedes Stellglied 13a bis 13c für ein Zeitintervall von $3\Delta t$ einen Beitrag zum Gesamtausgangsstrom I(t) liefert und anschließend für ein Zeitintervall von $6\Delta t$ den in der zugeordneten Solarzellengruppe erzeugten elektrischen Strom zwischenpuffert, um diesen zwischengepufferten Strom in dem folgenden Zeitintervall von $3\Delta t$ Dauer bereitzustellen. Gemäß dieser zeitlichen Abfolge tragen alle stromerzeugenden Solarzellengruppen gleichermaßen bzw. gleichviel zu dem Gesamtausgangsstrom I(t) bei.

Durch die partielle Abschattung ab dem Ereigniszeitpunkt $t_E$ muß eine andere zeitliche Abfolge durch die Regeleinrichtung vorgesehen werden. Da lediglich Strom für die Dauer eines Zeitintervals von $1\Delta t$ durch das dritte Stellglied 13c bereitgestellt werden kann, werden die Zeitintervalle für die übrigen Stellglieder 13a, 13b, in welchen elektrische Energie zwischengepuffert werden kann, kürzer. Der von dem ersten Stellglied 13a bereitgestellte erste Ausgangsstrom $I_A^{[1]}(t)$ umfaßt ab dem Ereigniszeitpunkt $t_E$ Rechteckimpulse 41 d, 41 e, 41 f, welche eine Zeitdauer von $2\Delta t$ aufweisen. Während dieses Zeitintervals trägt der erste Ausgangsstrom $I_A^{[1]}(t)$ zu dem Gesamtausgangsstrom I(t) bei. Zwischen zwei Rechteckimpulsen liegt ein Zeitintervall von $3\Delta t$, in welchem dann der zweite Ausgangsstrom $I_A^{[2]}(t)$ einen Rechteckimpuls einer Zeitdauer von $2\Delta t$ und der dritte Ausgangsstrom $I_A^{[3]}(t)$ einen Rechteckimpuls einer Zeitdauer von $1\Delta t$ aufweist.

Die über die Zeit t gemittelte elektrische Leistung des ersten und zweiten Ausgangsstromes sind vor und nach dem Ereigniszeitpunkt $t_E$ vorzugsweise im wesentlichen gleich groß. Jedoch sind die zeitlichen Funktionen der Ausgangsströme $I_A^{[1]}(t)$ und $I_A^{[2]}(t)$ derart angepaßt, daß die durch die Abschattung resultierende zeitliche Funktion des Ausgangsstroms $I_A^{[3]}(t)$ in der Superposition mit den zeitlichen Funktionen der übrigen Ausgangsströme einen möglichst konstanten Gesamtausgangsstrom I(t) ergibt.

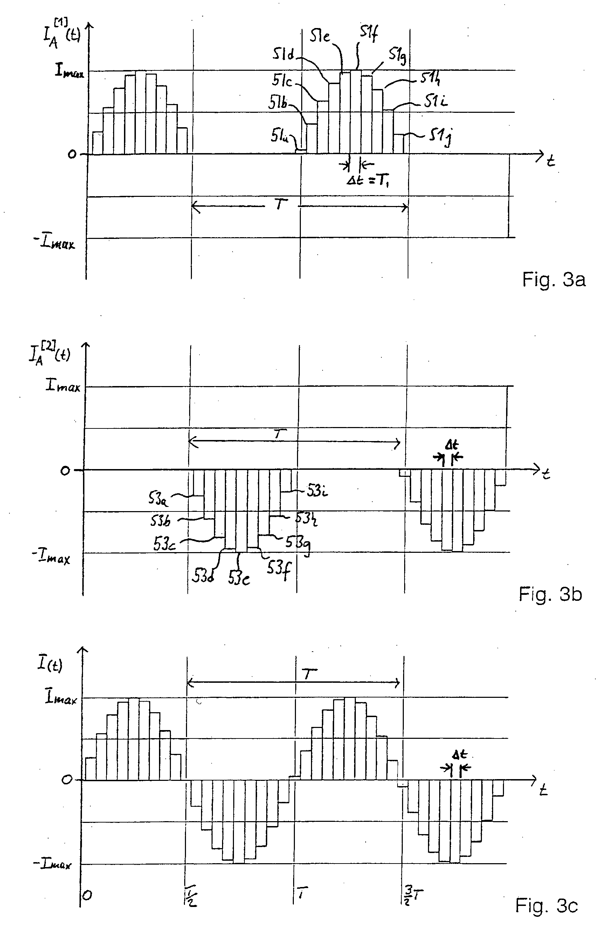

Die **Figuren 3a-c** zeigen eine beispielhafte Erzeugung eines sinusförmigen Gesamtausgangsstroms I(t) durch die Superposition zweier zeitlich variierender Ausgangsströme $I_A^{[1]}(t)$ und $I_A^{[2]}(t)$. Dabei zeigt die Figur 3a die über die Zeit t aufgetragene Ausgangsstromstärke $I_A^{[1]}(t)$ des ersten Ausgangsstroms und die Figur 3b die über die Zeit t aufgetragene Ausgangsstromstärke $I_A^{[2]}(t)$ des zweiten Ausgangsstroms. Die Figur 3c zeigt die Stromstärke des Gesamtausgangsstroms I(t), welcher durch die Superposition der einzelnen Ausgangsströme $I_A^{[1]}(t)$ und $I_A^{[2]}(t)$ erzeugt wird.

Die in den Figuren 3a und 3b gezeigten ersten und zweiten Ausgangsströme können jeweils an einem zugeordneten Stellglied eines Solarpaneels bereitgestellt werden. Der gezeigte zeitliche Verlauf des ersten Ausgangsstroms $I_A^{[1]}(t)$ umfaßt eine Mehrzahl von rechteckförmigen Stromimpulsen bzw. Rechteckimpulsen 51 a bis 51 j gleicher Zeitdauer bzw. gleicher Pulslänge $T_1 = \Delta t$. Jedoch weisen die einzelnen Rechteckimpulsen 51 a bis 51 j jeweils eine unterschiedliche Stromstärke auf.

Bevorzugt kann der zeitliche Verlauf des ersten Ausgangsstroms $I_A^{[1]}(t)$ zumindest abschnittsweise im wesentlichen der Sinusfunktion folgen. Weiter bevorzugt kann der zeitliche Verlauf des ersten Ausgangsstroms $I_A^{[1]}(t)$ wie in Figur 3a gezeigt eine zeitliche Periodizität mit der Periode T aufweisen. Mit anderen Worten kann sie der zeitliche Verlauf nach einer Periode von T wiederholen oder anders ausgedrückt:

$$I_A^{[1]}(t) = I_A^{[1]}(t+T).$$

In der in Figur 3a gezeigten bevorzugten Ausführungsform folgt der zeitliche Verlauf des ersten Ausgangsstroms $I_A^{[1]}(t)$ einer Sinusfunktion mit der Periode T lediglich für Sinusfunktionswerte größer als Null, wobei die maximale Stromstärke $I_{max}$ erreicht wird. Zu allen anderen Zeiten, in denen die Sinusfunktion negativ ist, ist der erste Ausgangsstrom gleich Null.

Zu dem ersten Ausgangsstrom komplementär verlaufend ist der in der Figur 3b gezeigte zeitliche Verlauf des zweiten Ausgangsstroms $I_A^{[2]}(t)$, welcher eine Mehrzahl von rechteckförmigen Stromstärkeimpulsen bzw. Rechteckimpulsen 53a bis 53i gleicher Zeitdauer bzw. gleichen Zeitintervalls $\Delta t$. Bevorzugt folgt der zeitliche Verlauf des zweiten Ausgangsstroms $I_A^{[2]}(t)$ im wesentlichen der Sinusfunktion mit der Periode T lediglich für Sinusfunktionswerte kleiner als Null, wobei die maximale Stromstärke $-I_{max}$ erreicht wird. Zu allen anderen Zeiten, in denen die Sinusfunktion positiv ist, ist der zweite Ausgangsstrom gleich Null.

Der in der Figur 3c gezeigte Gesamtausgangsstrom I(t) ist die Summe der in den Figuren 3a und 3b gezeigten Ausgangsströme. In der bevorzugten Ausführungsform werden der erste und zweite Ausgangsstrom mit einem solchen Zeitversatz miteinander superpositioniert, daß wie in Figur 3 gezeigt, ein sinusförmiger Wechselstrom resultiert, welcher zwischen den Stromstärkenextrema $-I_{max}$ und $I_{max}$ wechselt.

Bevorzugt beträgt die Periode T des Gesamtstroms I(t) etwa 0,020 s oder etwa 0,0167 s. Mit anderen Worten weist der Gesamtstrom I(t) eine Frequenz von etwa 50 Hz oder etwa 60 Hz auf. Die Pulslänge bzw. die Zeitdauer $T_1 = \Delta t$ der einzelnen Rechteckimpulse ist kleiner als die Periode T. Bevorzugt ist $\Delta t$ kleiner oder gleich T/2, weiter bevorzugt ist $\Delta t$ kleiner oder gleich T/4, weiter bevorzugt ist $\Delta t$ kleiner oder gleich T/8, besonders bevorzugt ist $\Delta t$ kleiner oder gleich T/16, insbesondere ist $\Delta t$ kleiner oder gleich T/32. Beispielsweise ist $\Delta t$ kleiner als 10 ms, kleiner als 5 ms, kleiner als 2 ms, kleiner als 1 ms und insbesondere kleiner als 0,5 ms.

Vorteilhafterweise kann der Gesamtausgangsstrom I(t) besser einer Sinusfunktion entsprechen bzw. diese approximieren, je kleiner das Zeitintervall $\Delta t$ im Verhältnis zur Periode T ist.

Es versteht sich, daß ein beliebiger Gesamtausgangsstrom I(t), beispielsweise in Form eines Gleichstroms oder eines Wechselstroms, durch eine beliebige Anzahl von Ausgangsströmen superpositioniert werden kann. Das Solarpaneel bzw. die Anschlußdose muß dann eine entsprechende Anzahl von Stellgliedern und eine geeignete Regeleinrichtung aufweisen.

Bezuaszeichenliste

| | |
|---|---|
| 1 | Solarpaneel |
| 3 | Solarmodul |
| 4a-4c | Solarzellengruppen des Solarmoduls 3 |
| 5a-5f | elektrischer Leiter des Solarmoduls 3 |
| 7 | Anschlußdose |
| 11 a-11 c | erster Leiterkontakt |
| 12a-12c | zweiter Leiterkontakt |

| 13a-13c | Stellglied |
|---|---|
| 15a, 15b | Anschlußpol |
| 17 | Regeleinrichtung |
| 19 | Steuerleitung |
| 21 | Schnittstelle |
| 23 | Rückkopplungseinrichtung |
| 25 | Mikroprozessor |
| 27 | Strommeßeinrichtung |
| 29 | Spannungsmeßeinrichtung |
| 31 | Temperaturmeßeinrichtung |
| 33 | Stromquelle |
| 41a-41f | Stromimpulse des ersten Ausgangsstroms |
| 43a-43f | Stromimpulse des zweiten Ausgangsstroms |
| 45a-45e | Stromimpulse des dritten Ausgangsstroms |
| 51a-51j | Stromimpulse des ersten Ausgangsstroms |
| 53a-53i | Stromimpulse des zweiten Ausgangsstroms |

**Patentansprüche**

1. Anschlußdose (7) für ein Solarmodul (3) umfassend:

   - einen ersten (15a) und zweiten Anschlußpol (15b);
   - eine Anzahl von N Stellgliedern (13a, 13b, 13c) mit der Anzahl N ≥ 2, wobei jedes der N Stellglieder (13a, 13b, 13c) mit dem ersten Anschlußpol (15a) und dem zweiten Anschlußpol (15b) elektrisch verbunden ist, wobei jedes der N Stellglieder (13a, 13b, 13c) einen zugeordneten ersten elektrischen Leiterkontakt (11a, 11b, 11 c) und einen zugeordneten zweiten elektrischen Leiterkontakt (12a, 12b, 12c) aufweist, und wobei jeder der ersten elektrischen Leiterkontakte (11a, 11 b, 11 c) und jeder der zweiten elektrischen Leiterkontakte (12a, 12b, 12c) mit einem zugeordneten elektrischen Leiter (5a-5f) des Solarmoduls (3) elektrisch kontaktierbar ist;
   - eine Regeleinrichtung (17), welche mit jedem der N Stellglieder (13a, 13b, 13c) elektrisch verbunden ist,

   wobei das n-te der N Stellglieder (13a, 13b, 13c) mit n ∈ [1...N] einen über eine Zeit t vorgegebenen elektrischen Eingangsstrom $I_E^n(t)$, welcher über die zugeordneten ersten (11a, 11b, 11c) und zweiten (12a, 12b, 12c) elektrischen Leiterkontakte dem n-ten der Stellglieder (13a, 13b, 13c) zugeführt wird, in einen durch die Regeleinrichtung (17) vorbestimmten zeitlich variablen Ausgangsstrom $I_A^n(t)$ konvertiert, so daß ein vorbestimmten superpositionierter

   Ausgangsstrom $I(t) = \sum_{n=1}^{N} I_A^n(t)$ an dem ersten (15a) und zweiten Anschlußpol (156), bereitgestellt wird, wobei wahlweise ein Gleichstrom oder ein Wechselstrom bereitgestellt wird
   oder
   wobei das n-te der N Stellglieder (13a, 13b, 13c) mit n ∈ [1...N] eine über die Zeit t vorgegebene elektrische Eingangsspannung $U_E^n(t)$, welche an den zugeordneten ersten (11a, 11b, 11 c) und zweiten (12a, 12b, 12c) elektrischen Leiterkontakten des n-ten der N Stellglieder (13a, 13b, 13c) anliegt, in eine durch die Regeleinrichtung (17) vorbestimmte zeitlich variable Ausgangsspannung $U_A^n(t)$ konvertiert, so daß eine vorbestimmte superpositionierte

   Ausgangsspannung $U(t) = \sum_{n=1}^{N} U_A^n(t)$ zwischen dem ersten (15a) und zweiten Anschlußpol (15b) angelegt wird, wobei wahlweise eine Gleichspannung oder eine Wechselspannung bereitgestelt wird.

2. Anschlußdose (7) nach Anspruch 1, wobei die Stellglieder (13a, 13b, 13c) Gleichstromsteller sind und/oder zumindest einen Metalloxid-Feldeffekttransistor umfassen.

3. Anschlußdose (7) nach einem der vorigen Ansprüche, wobei die N Stellglieder (13a, 13b, 13c) mittels der Regeleinrichtung (17) miteinander zeitlich synchronisierbar sind.

**4.** Anschlußdose (7) nach einem der vorigen Ansprüche, mit zumindest einer Rückkopplungseinrichtung (23), welche den superpositionierten Ausgangsstrom I(t) und/oder die superpositionierte Ausgangsspannung U(t) an dem ersten Anschlußpol (15a) und/oder dem zweiten Anschlußpol (15b) erfaßt, und welche mit der Regeleinrichtung (17) verbunden ist.

**5.** Anschlußdose (7) nach einem der vorigen Ansprüche, wobei der superpositionierte Ausgangsstrom I(t) ein periodischer Strom und/oder die superpositionierte Ausgangsspannung U(t) eine periodische Spannung ist.

**6.** Anschlußdose (7) nach Anspruch 5, wobei der superpositionierte Ausgangsstrom I(t) ein Wechselstrom und/oder die superpositionierte Ausgangsspahnung U(t) eine Wechselspannung ist.

**7.** Anschlußdose (7) nach einem der vorigen Ansprüche, wobei die Regeleinrichtung (17) eine Schnittstelle (21) aufweist, so daß die Regeleinrichtung (17) mit einer externen Steuereinrichtung verbindbar ist.

**8.** Anschlußdose (7) nach einem der vorigen Ansprüche, mit zumindest einer Meßeinrichtung (27, 29, 31), welche mit der Regeleinrichtung (17) verbunden ist.

**9.** Solarpaneel (1) umfassend:

   - zumindest ein Solarmodul (3) mit zumindest vier elektrischen Leitern (5a-5d) und
   - eine Anschlußdose (7) gemäß einem der vorigen Ansprüche, wobei jeder der ersten elektrischen Leiterkontakte (11a, 11b, 11c) der Anschlußdose (7) und jeder der zweiten elektrischen Leiterkontakte (12a, 12b, 12c) mit einem zugeordneten elektrischen Leiter (5a-5d) des Solarmoduls (3) elektrisch kontaktiert ist.

**10.** Verwendung einer Anschlußdose (7) gemäß einem der Ansprüche 1 bis 8, um einen elektrischen Verbraucher mit einem Solarmodul (3) zu kontaktieren, wobei jeder der ersten elektrischen Leiterkontakte (11a, 11b, 11 c) der Anschlußdose (7) und jeder der zweiten elektrischen Leiterkontakte (12a, 12b, 12c) mit einem zugeordneten elektrischen Leiter (5a-5d) des Solarmoduls (3) elektrisch kontaktiert ist und wobei der elektrische Verbraucher mit einem ersten Anschlußpol (15a) und einem zweiten Anschlußpol (15b) der Anschlußdose (7) elektrisch verbunden ist.

**11.** Verfahren zum Erzeugen eines vorbestimmten Ausgangsstroms I(t) oder einer vorbestimmten Ausgangsspannung U(t) umfassend die folgenden Schritte:

   - Bereitstellen eines Solarpaneels (1) gemäß Anspruch 9,
   - Vorbestimmen eines Ausgangsstroms I(t) und/oder einer Ausgangsspannung U(t);
   - Bereitstellen des vorbestimmten Ausgangsstroms I(t) und/oder der vorbestimmten Ausgangsspannung U(t) an der Regeleinrichtung (17) des Solarpaneels (1);
   - Regeln einer Anzahl von N Stellgliedern (13ä, 13b, 13c) des Solarpaneels (1) mittels der Regeleinrichtung (17), wobei die Anzahl $N \geq 2$ ist, so daß das n-te der N Stellglieder (13a, 13b, 13c) mit $n \in [1...N]$ einen über eine Zeit t vorgegebenen elektrischen Eingangsstrom $I_E^n(t)$ in einen durch die Regeleinrichtung (17) vorbestimmbaren zeitlich variablen Ausgangsstrom $I_A^n(t)$ konvertiert, und Überlagern der N zeitlich variablen Ausgangsströme $I_A^n(t)$, um einen superpositionierten Ausgangsstrom $I(t) = \sum_{n=1}^{N} I_A^n(t)$ an dem ersten (15a) und zweiten Anschlußpol (15b) des Solarpaneels (1) bereitzustellen,
   oder
   - Regeln einer Anzahl von N Stellgliedern (13a, 13b, 13c) des Solarpaneels (1) mittels der Regeleinrichtung (17), wobei die Anzahl $N \geq 2$ ist, so daß das n-te der N Stellglieder (13a, 13b, 13c) mit $n \in [1...N]$ einer über eine Zeit t vorgegebenen elektrischen Eingangsspannung $U_E^n(t)$ in eine durch die Regeleinrichtung (17) vorbestimmbare zeitlich variable Ausgangsspannung $U_A^n(t)$ konvertiert, und Überlagern der N zeitlich variablen Ausgangsspannungen $U_A^n(t)$, um eine superpositionierte Ausgangsspannung $U(t) = \sum_{n=1}^{N} U_A^n(t)$ an dem ersten (15a) und zweiten Anschlußpol (15b) des Solarpaneels (1) bereitzustellen.

**Claims**

1. Connection box (7) for a solar module (3) comprising:

   - a first (15a) and a second connection pole (15b);
   - a number of N actuating members (13a, 13b, 13c) with the number N ≥ 2;
   wherein each of the N actuating members (13a, 13b, 13c) is electrically connected to the first connection pole (15a) and the second connection pole (15b),
   wherein each of the N actuating members (13a, 13b, 13c) has an associated first electrical conductor contact (11a, 11 b, 11c) and an associated second electrical conductor contact (12a, 12b, 12c), and wherein each of the first electrical conductor contacts (11 a, 11 b, 11c) and each of the second electrical conductor contacts (12a, 12b, 12c) is electrically contactable with an associated electrical conductor (5a-5f) of the solar module (3);
   - a control device (17), which is electrically connected to each of the N actuating members (13a, 13b, 13c),

   wherein the n-th of the N actuating members (13a, 13b, 13c) with $n \in [1...N]$ converts an electrical input current $I_E^n(t)$ predefined over a time t, which is supplied to the n-th of the actuating members (13a, 13b, 13c) via the associated first (11 a, 11b, 11c) and second (12a, 12b, 12c) electrical conductor contacts, into a time-variable output current $I_A^n(t)$ predetermined by the control device (17), such that a predetermined super positioned output current

   $$I(t) = \sum_{n=1}^{N} I_A^n(t)$$ is provided at the first (15a) and the second connection pole (15b),

   wherein optionally a direct current or an alternating current is provided or
   wherein the n-th of the N actuating members (13a, 13b, 13c) with $n \in [1...N]$ converts an electrical input voltage $U_E^n(t)$ predefined over the time t, which is applied at the associated first (11 a, 11 b, 11 c) and second (12a, 12b, 12c) electrical conductor contacts of the n-th of the N actuating members (13a, 13b, 13c), into a time-variable output voltage $U_A^n(t)$ predetermined by the control device (17), such that a predetermined superpositioned output voltage

   $$U(t) = \sum_{n=1}^{N} U_A^n(t)$$ is being applied between the first (15a) and the second connection pole (15b),

   wherein optionally a direct voltage or an alternating voltage is provided.

2. Connection box (7) according to claim 1, wherein the actuating members (13a, 13b, 13c) are direct current choppers and/or comprise at least one metal oxide field effect transistor.

3. Connection box (7) according to one of the preceding claims, wherein the N actuating members (13a, 13b, 13c) are time-synchronizable with each other by means of the control device (17).

4. Connection box (7) according to one of the preceding claims, having at least one feedback device (23), which detects the superpositioned output current I(t) and/or the superpositioned output voltage U(t) at the first connection pole (15a) and/or the second connection pole (15b), and which is connected to the control device (17).

5. Connection box (7) according to one of the preceding claims, wherein the superpositioned output current I(t) is a periodic current and/or the superpositioned output voltage U(t) is a periodic voltage.

6. Connection box (7) according to claim 5, wherein the superpositioned output current I(t) is an alternating current and/or the superpositioned output voltage U(t) is an alternating voltage.

7. Connection box (7) according to one of the preceding claims, wherein the control device (17) has an interface (21), such that the control device (17) is connectable to an external control element.

8. Connection box (7) according to one of the preceding claims, having at least one measuring device (27, 29, 31), which is connected to the control device (17).

9. Solar panel (1) comprising:

   - at least one solar module (3) with at least four electrical conductors (5a-5d) and
   - a connection box (7) according to one of the preceding claims, wherein each of the first electrical conductor contacts (11 a, 11 b, 11c) of the connection box (7) and each of the second electrical conductor contacts (12a, 12b, 12c) is electrically contacted with an associated electrical conductor (5a-5d) of the solar module (3).

10. Use of a connection box (7) according to one of claims 1 to 8, for contacting an electrical consumer with a solar module (3),
wherein each of the first electrical conductor contacts (11 a, 11 b, 11c) of the connection box (7) and each of the second electrical conductor contacts (12a, 12b, 12c) is electrically contacted with an associated electrical conductor (5a-5d) of the solar module (3) and
wherein the electrical consumer is electrically connected to a first connection pole (15a) and a second connection pole (15b) of the connection box (7).

11. Method for generating a predetermined output current I(t) or a predetermined output voltage U(t) comprising the following steps:

- providing a solar panel (1) according to claim 9,
- predetermining an output current I(t) and/or an output voltage U(t);
- providing the predetermined output current I(t) and/or the predetermined output voltage U(t) at the control device (17) of the solar panel (1);
- controlling a number of N actuating members (13a, 13b, 13c) of the solar panel (1) by means of the control device (17), wherein the number is $N \geq 2$, such that the n-th of the N actuating members (13a, 13b, 13c) with $n \in [1...N]$ converts an electrical input current $I_E^n(t)$ predefined over a time t into a time-variable output current $I_A^n(t)$ predeterminable by the control device (17), and overlapping the N time-variable output currents $I_A^n(t)$ in

order to provide a superpositioned output current $I(t) = \sum_{n=1}^{N} I_A^n(t)$ at the first (15a) and the second connection pole (15b) of the solar panel (1),
or
- controlling a number of N actuating members (13a, 13b, 13c) of the solar panel (1) by means of the control device (17), wherein the number is $N \geq 2$, such that the n-th of the N actuating members (13a, 13b, 13c) with $n \in [1...N]$ converts an electrical input voltage $U_E^n(t)$ predefined over a time t into a time-variable output voltage $U_A^n(t)$ predeterminable by the control device (17), and overlapping the N time-variable output voltages $U_A^n(t)$

in order to provide a superpositioned output voltage $U(t) = \sum_{n=1}^{N} U_A^n(t)$ at the first (15a) and the second connection pole (15b) of the solar panel (1).

**Revendications**

1. Boîte de jonction (7) pour un module solaire (3) comprenant :

- une première (15a) et seconde borne de raccordement (15b) ;
- un nombre de N composants de réglage (13a, 13b, 13c) avec le nombre $N \geq 2$,
dans laquelle chacun des N composants de réglage (13a, 13b, 13c) est relié électriquement à la première (15a) et la seconde borne de raccordement (15b), dans laquelle chacun des N composants de réglage (13a, 13b, 13c) présente un premier contact de conducteur électrique associé (11a, 11b, 11c) et un second contact de conducteur électrique associé (12a, 12b, 12c), et
dans laquelle chacun des premiers contacts de conducteur électriques (11a, 11b, 11c) et chacun des seconds contacts de conducteur électriques (12a, 12b, 12c) peut venir en contact électriquement avec un conducteur électrique associé (5a à 5f) du module solaire (3) ;
- un dispositif de régulation (17) qui est relié électriquement à chacun des N composants de réglage (13a, 13b, 13c),

dans laquelle le n-ième des N composants de réglage (13a, 13b, 13c) convertit avec $n \in [1...N]$ un courant d'entrée électrique prédéfini sur un temps t $I_E^n(t)$ qui est acheminé par le biais des premier (11a, 11b, 11c) et second (12a, 12b, 12c) contacts de conducteur électriques associés au n-ième des composants de réglage (13a, 13b, 13c) en un courant de sortie variable dans le temps prédéterminé par le dispositif de régulation (17) $I_A^n(t)$ de sorte qu'un courant de sortie superposé prédéterminé

$$I(t) = \sum_{n=1}^{N} I_A^n(t)$$

est mis à disposition au niveau de la première (15a) et seconde borne de raccordement (15b), dans laquelle un courant continu ou un courant alternatif est mis à disposition au choix
ou
dans laquelle le n-ième des N composants de réglage (13a, 13b, 13c) convertit avec $n \in [1...N]$ une tension d'entrée électrique prédéfinie sur le temps t $U_E^n(t)$ qui s'applique aux premier (11a, 11b, 11c) et second (12a, 12b, 12c) contacts de conducteur électriques associés du n-ième des N composants de réglage (13a, 13b, 13c) en une tension de sortie variable dans le temps prédéterminée par le dispositif de régulation (17) $U_A^n(t)$ de sorte qu'une tension de sortie superposée prédéterminée

$$U(t) = \sum_{n=1}^{N} U_A^n(t)$$

est appliquée entre la première (15a) et seconde borne de raccordement (15b), dans laquelle une tension continue ou une tension alternative est mise à disposition au choix.

2. Boîte de jonction (7) selon la revendication 1, dans laquelle les composants de réglage (13a, 13b, 13c) sont des convertisseurs directs de courant continu et/ou comprennent au moins un transistor à effet de champ en oxyde métallique.

3. Boîte de jonction (7) selon une des revendications précédentes, dans laquelle les N composants de réglage (13a, 13b, 13c) peuvent être synchronisés dans le temps les uns avec les autres au moyen du dispositif de régulation (17).

4. Boîte de jonction (7) selon une des revendications précédentes, avec au moins un dispositif de rétroaction (23) qui détecte le courant de sortie superposé I (t) et/ou la tension de sortie superposée U(t) au niveau de la première borne de raccordement (15a) et/ou de la seconde borne de raccordement (15b), et qui est relié au dispositif de régulation (17).

5. Boîte de jonction (7) selon une des revendications précédentes, dans laquelle le courant de sortie superposé I(t) est un courant périodique et/ou la tension de sortie superposée U(t) est une tension périodique.

6. Boîte de jonction (7) selon la revendication 5, dans laquelle le courant de sortie superposé I(t) est un courant alternatif et/ou la tension de sortie superposée U(t) est une tension alternative.

7. Boîte de jonction (7) selon une des revendications précédentes, dans laquelle le dispositif de régulation (17) présente une interface (21) de sorte que le dispositif de régulation (17) peut être relié à un dispositif de commande externe.

8. Boîte de jonction (7) selon une des revendications précédentes, avec au moins un dispositif de mesure (27, 29, 31) qui est relié au dispositif de régulation (17).

9. Panneau solaire (1) comprenant:

   - au moins un module solaire (3) avec au moins quatre conducteurs électriques (5a à 5d) et
   - une boîte de jonction (7) selon une des revendications précédentes, dans lequel chacun des premiers contacts de conducteur électriques (11a, 11b, 11c) de la boîte de jonction (7) et chacun des seconds contacts de conducteur électriques (12a, 12b, 12c) vient en contact électriquement avec un conducteur électrique associé (5a à 5d) du module solaire (3).

10. Utilisation d'une boîte de jonction (7) selon une des revendications 1 à 8 pour mettre en contact un récepteur électrique avec un module solaire (3),

dans laquelle chacun des premiers contacts de conducteur électriques (11a, 11b, 11c) de la boîte de jonction (7) et chacun des seconds contacts de conducteur électriques (12a, 12b, 12c) vient en contact électriquement avec un conducteur électrique associé (5a à 5d) du module solaire (3), et

dans lequel le récepteur électrique est relié électriquement à une première borne de raccordement (15a) et une seconde borne de raccordement (15b) de la boîte de jonction (7).

11. Procédé de génération d'un courant de sortie prédéterminé I(t) ou d'une tension de sortie prédéterminée U(t) comprenant les étapes suivantes :

- mise à disposition d'un panneau solaire (1) selon la revendication 9,
- prédétermination d'un courant de sortie I(t) et/ou d'une tension de sortie U(t) ;
- mise à disposition du courant de sortie prédéterminé I(t) et/ou de la tension de sortie prédéterminée U(t) au niveau du dispositif de régulation (17) du panneau solaire (1) ;
- régulation d'un nombre de N composants de réglage (13a, 13b, 13c) du panneau solaire (1) au moyen du dispositif de régulation (17), dans lequel le nombre est $N \geq 2$ de sorte que le n-ième des N composants de réglage (13 a, 13b, 13c) convertit avec $n \in [1...N]$ un courant d'entrée électrique prédéfini sur un temps t $I_E^n(t)$ en un courant de sortie variable dans le temps pouvant être prédéterminé par le dispositif de régulation (17) $I_A^n(t)$, et superposition des N courants de sortie variables dans le temps $I_A^n(t)$ pour mettre à disposition un courant de sortie superposé

$$I(t) = \sum_{n=1}^{N} I_A^n(t)$$

au niveau de la première (15a) et seconde borne de raccordement (15b) du panneau solaire (1), ou
- régulation d'un nombre de N composants de réglage (13a, 13b, 13c) du panneau solaire (1) au moyen du dispositif de régulation (17), dans lequel le nombre est $N \geq 2$ de sorte que le n-ième des N composants de réglage (13a, 13b, 13c) convertit avec $n \in [1...N]$ une tension d'entrée électrique prédéfinie sur un temps t $U_E^n(t)$ en une tension de sortie variable dans le temps pouvant être prédéterminée par le dispositif de régulation (17) $U_A^n(t)$, et superposition des N tensions de sortie variables dans le temps $U_A^n(t)$ pour mettre à disposition une tension de sortie superposée

$$U(t) = \sum_{n=1}^{N} U_A^n(t)$$

au niveau de la première (15a) et seconde borne de raccordement (15b) du panneau solaire (1).

Fig. 1

EP 2 437 371 B1

Fig. 2a

Fig. 2b

Fig. 2c

Fig. 2d

Fig. 3a

Fig. 3b

Fig. 3c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19635606 A1
- WO 2009146065 A2
- DE 102008008505 A1